# EUROPEAN PATENT APPLICATION

(11) **EP 4 290 593 A1**
(43) Date of publication of application: **13.12.2023**
(21) Application number: 21924047.0
(22) Date of filing: 27.05.2021
(51) Int. Cl.: H01L 31/18, H01L 21/223

(54) **BORON DIFFUSION METHOD SUITABLE FOR HBC BATTERY**

(30) Priority: 02.02.2021 CN 202110140582
(71) Applicant: Popsolar Technology (Taixing) Co., Ltd, Taizhou,Jiangsu 225400 (CN)
(72) Inventor: OU, Wenkai, Xuzhou, Jiangsu 221000 (CN)
(74) Representative: De Arpe Tejero, Manuel
(86) International application number: PCT/CN2021/096259
(87) International publication number: WO 2022/166040

(57) **Abstract**

A boron diffusion method suitable for HBC solar cells is provided. In a propelling step, a nitrogen and oxygen hybrid propelling mode is used, and a propelling time is increased, such that a junction depth can be effectively increased and a surface concentration can be effectively reduced. Moreover, a nitrogen propelling time is included, such that a concentration of boron in BSG is reduced, and the BSG is easier to be removed completely. For N-type solar cells, the method has excellent front surface doping capability, a thinner dead layer, and good light absorption capability. In addition, the method uses a horizontal diffusion mode and has good single-side performance, and utilizes a gravity press mode to make silicon wafers be placed back-to-back in horizontal grooves, such that silicon wafers are pressed mutually under the influence of the gravity of an upper silicon wafer, the deformation is very small after being heated at a high temperature, which can effectively avoid the occurrence of winding diffusion. The diffusion of boron towards a back surface is reduced during diffusion, and thus winding diffusion on the back surface is greatly reduced.

## Description

### TECHNICAL FIELD

The invention relates to a boron diffusion method suitable for heterojunction back contact (HBC) solar cells.

### BACKGROUND

Among all solar cells, a silicon solar cell is the most commercially promoted solar cell. A photovoltaic solar cell can directly convert solar energy into electrical energy, and its power generation principle is based on a photovoltaic effect of a semiconductor PN junction.

A P-type silicon wafer needs a diffusion of phosphorus element therein to obtain PN junctions, and an N-type silicon wafer needs a diffusion of born element therein to obtain PN junctions. In a production process of solar cells, some processes such as a boron diffusion process, a phosphorus diffusion process, a low-pressure boron diffusion process and a low-pressure phosphorus diffusion process, require to diffuse or deposit some elements on the silicon wafer to form a certain thin layer structure.

The diffusion process is one of most critical procedures in the preparation of solar cells. The quality of diffusion result will directly affect the cell efficiency, and criteria for evaluating diffusion quality are a sheet resistance, a surface concentration and a junction depth. For the boron diffusion, as long as it has little impact on a contact resistance, the lower the surface concentration the better, which can reduce a surface recombination rate and increase open-circuit voltage and current. Moreover, a deeper junction depth can enhance a field effect of a front surface of an N-type solar cell and is beneficial to an improvement of fill factor (FF).

At present, a step of junction propelling in the boron diffusion process on the market employs a single high-temperature oxidation propelling. Such propelling method can quickly reduce the surface concentration, and can separate out boron in a silicon wafer surface by using an interface displacement generated by a reaction of silicon with oxygen to generate silicon dioxide, so that a total doping amount of boron in the silicon wafer is reduced during the high-temperature oxidation propelling, and the requirement of low surface concentration is met consequently. However, on one hand, it will produce a shallow junction depth, resulting in weakening of the field effect on the front surface; on the other hand, it will increase a concentration of boron in a borosilicate glass (BSG) layer, resulting in difficult cleaning of the BSG layer, thus it is necessary to increase a concentration of hydrogen fluoride (HF) and cleaning time during BSG cleaning, and a passivation of aluminum oxide (AlOx) can only be performed after the BSG layer is completely removed.

### SUMMARY

In view of the above situation, in order to overcome the defects of the related art, embodiments of the invention provide a boron diffusion method suitable for HBC solar cells.

To achieve the above purpose, the invention provides technical solutions as follows.

Specifically, a boron diffusion method suitable for HBC solar cells, includes the following step (1) ~ step (8).

Step (1) of boating entering, includes: placing silicon wafers in a boat and then performing an entering operation for the boat, wherein during performing the entering operation for the boat, a furnace tube has a temperature of 700°C - 750 °C and simultaneously is maintained with 2000 sccm of nitrogen (N₂) for continuous blowing.

Step (2) of heating-up and leak detection, includes: heating-up after the boat enters the furnace tube until a target temperature of 800-850 °C, vacuumizing while the heating-up, turning off a vacuum pump and performing leak detection with a leak detection requirement of less than 5 mbar/min after completion of the vacuumizing; and after completion of the leak detection, turning on the vacuum pump to adjust a pressure in the furnace tube until a target vacuum degree of 100-500 mbar.

Step (3) of pre-oxidation, includes: after reaching the target temperature and the target vacuum degree, introducing 2000 sccm -10000 sccm of oxygen (O₂) for pre-oxidation for 10-30 min. A thin silicon oxide layer is grown on a surface of the silicon wafer through the pre-oxidation, and the thin silicon oxide layer serves as a barrier layer, which can prevent the surface of the silicon wafer from being damaged by chloride generated by decomposition of BCl₃ gas.

Step (4) of evacuating, includes: after completion of the pre-oxidation, evacuating the furnace tube for an evacuation time of 3-10 min until a target pressure of less than 200 mbar.

Step (5) of boron source introduction and deposition, includes: introducing BCl₃ gas and oxygen for an introduction time of 5-20 min as per a gas volume ratio of the BCl₃ gas to the oxygen is 1:1 ~ 1:3. More specifically, a relatively low ratio may cause that BCl₃ cannot react with O₂ completely, resulting in excessive self-decomposition of BCl₃, and thus a large amount of elemental boron is deposited on the surface of silicon wafer to form a loss layer, and meanwhile, Cl₂ generated by the decomposition is very easy to corrode the surface of the silicon wafer; whereas, a relatively high ratio may cause insufficient concentration of BCl₃, resulting in uneven distribution of gas sources in the furnace tube of quartz, and thereby resulting in poor uniformity of whole tube.

Step (6) of heating-up, includes: after completion of boron source introduction and deposition, evacuating the furnace tube of quartz and heating-up after completion of the evacuating until another target temperature of 1000 °C.

Step (7) of propelling, includes: after reaching the another target temperature, alternately introducing N₂ and O₂ for propelling according to a ratio of a N₂ propelling time to a O₂ propelling time being 1:2 ~ 1:3 in each time of propelling. Preferably, the N₂ propelling time in each time of propelling is 10 min -25 min.

In a preferred embodiment, a flow rate of the N₂ is 3 SLM ~ 10 SLM and a flow rate of the O₂ is 5 SLM ~20 SLM in each time of propelling, and the propelling is cyclically performed for 2-5 times. The repeated cyclic propelling can effectively ensure lower surface concentration and deeper PN junction depth, greatly reduce a boron (B) source amount in BSG, greatly improve the minority carrier lifetime after B diffusion, and also reduce a processing difficulty of subsequent processing procedures.

O₂ propelling can ensure a continuous growth of an oxide layer, and B atoms are continuously propelled into a body of the silicon waferto ensure a doping concentration, but meanwhile, a solid solubility of B atom in the silicon oxide is greater than that in the silicon, thus the continuous growth of silicon oxide will lead to a large number of B atoms being absorbed into the silicon oxide layer, resulting in an excessive high boron concentration in BSG to form a boron-rich layer, the boron-rich layer reacts slowly with an acid, and thus it is not conducive to subsequent cleaning operation. Therefore, illustrated embodiments of the invention introduce N₂ propelling alternately performed with O₂ propelling, and can avoid a long-term N₂ propelling to cause a high concentration of B atom in the body of the silicon wafer, since an excessive high proportion of unactivated B would form a dead layer, causing a serious surface recombination, reduction of minority carrier lifetime and reduction of cell efficiency.

Step (8) of cooling down and boat exiting, includes: cooling down to 800 °C and then performing an exiting operation for the boat, thereby completing a diffusion process.

In an embodiment, in the step (2), a heating rate is 10 °C/min.

In an embodiment, in the step (7), after reaching the another target temperature, introducing 3000 sccm of the nitrogen for 10 min, introducing 5000 sccm of the oxygen for 25 min, introducing 3000 sccm of the nitrogen for 10 min, and introducing 5000 sccm of the oxygen for 25 min sequentially in that order.

Beneficial effects can be achieved by the invention are as follows.
(1) The step of propelling uses a hybrid propelling mode of nitrogen and oxygen in the illustrated embodiments of the invention, and the propelling time is increased, so that a junction depth can be effectively increased and a surface concentration can be effectively reduced. Moreover, the nitrogen propelling time is included, so that a concentration of B in the BSG is reduced, and thus the BSG is more easily removed. ECV results showed that: by using the method of the invention, the junction depth is increased, and the surface concentration is lower than that of the existing boron diffusion method.
(2) In the illustrated embodiments of the invention, inclusion of the nitrogen propelling time makes the concentration of B in the BSG be reduced, the BSG is easier to remove. In a cleaning process, a concentration ratio of a solution is H₂O : HF = 20:1 (volume ratio), a temperature is the ambient temperature, and a BSG cleaning time is reduced from 600 seconds to 500 seconds, which reduces the cleaning time by 100 seconds.
(3) For an N-type solar cell, the method of the illustrated embodiments of the invention has excellent front surface doping capability, a thinner dead layer and better light absorption capability. Moreover, the illustrated embodiments of the invention use a horizontal diffusion mode and has better single-side performance, and utilizes a mode of gravity press (the gravity press is that: the boron diffusion employs a horizontal wafer placement and diffusion mode, adjacent two of silicon wafers are stacked together, and the upper wafer is pressed on the lower wafer under the action of gravity) to place silicon wafers in a back-to-back manner in a horizontal groove. The silicon wafers are mutually pressed under the influence of the gravity of the upper silicon wafer, and the deformation is very small after being heated at a high temperature, which can effectively prevent the occurrence of winding diffusion, the diffusion of B towards the back surface is reduced in the diffusion process, thus the winding diffusion on the back surface is greatly reduced, and therefore the method of the invention is particularly important for a high-efficiency solar cell with high requirement of single-side performance.
(4) The diffusion method according to illustrated embodiments of the invention is particularly suitable for N-type HBC high-efficiency solar cells, a back surface process of the HBC solar cell is more complex, and the superior single-side performance and excellent BSG layer greatly reduce the difficulty of subsequent treatment process, which is conducive to the industrialization of HBC products.

### BRIEF DESCRIPTION OF THE DRAWINGS

FIG. 1 illustrates an electrochemical capacitance-voltage (ECV) diagram of boron diffusions respectively in a method according to an embodiment of the invention and a method of comparative example 1.
FIG. 2 illustrates photoluminescence (PL) pictures of photovoltaic solar cells obtained after boron diffusions using a method of a comparative example 1 and a method of the embodiment 1 of the invention, respectively.
FIG. 3 illustrates test positions during sampling and testing.

### DETAILED DESCRIPTION OF THE EMBODIMENTS

Technical solutions of the invention will be described below in detail with reference to the accompanying drawings. It should be indicated that embodiments described below are merely detailed description of the invention and should not be construed as limiting the invention.

### Embodiment 1

A boron diffusion method suitable for HBC solar cells includes steps as follows.
(1) Step of boat entering. Specifically, silicon wafers after being texturing cleaned are placed into a horizontal insertion-type quartz boat, the silicon wafers are inserted into horizontal quartz grooves in a back-to-back manner (e.g., adjacent two of the silicon wafers are placed in the same horizontal quartz groove in the back-to-back manner), and then the quart boat is performed with an entering operation to enter a quartz furnace tube. When the quartz boat enters the quartz furnace tube, the quartz furnace tube has a temperature of 700 degrees Celsius (°C), and simultaneously is maintained with 2000 standard cubic centimeter per minute (sccm) of nitrogen (N₂) for continuous blowing.
(2) Step of heating-up and leak detection. Specifically, the silicon wafers and the quartz boat after entering the quartz furnace tube are heated up with a heating rate of 10 degrees Celsius per minute (°C/min) until a target temperature of 850 °C, and the furnace tube is vacuumized through a vacuum pump while the heating-up. After the vacuumizing is completed, the vacuum pump is turned off and vacuum leak detection is performed as per a leak detection requirement of less than 5 millibars per minute (mbar/min). After the leak detection is completed, the vacuum pump is turned on to adjust a pressure in the furnace tube, and a target vacuum degree is 200 mbar.
(3) Step of pre-oxidation. Specifically, after reaching the target temperature and the target vacuum degree, 2000 sccm of oxygen is introduced for pre-oxidation for 10 min, and a thin silicon oxide layer is grown on a surface of each the silicon wafer through the pre-oxidation. The thin silicon oxide layer serves as a barrier layer, which can prevent the surface of the silicon wafer from being damaged by chloride generated by decomposition of BCl₃ gas.
(4) After the pre-oxidation is completed, the furnace tube is evacuated to remove oxygen in the furnace tube, and a target pressure is less than 200 mbar, so as to prevent excessive oxygen from remaining in the furnace tube and thereby prevent excessive oxygen to consume a source of BCl₃ in a next step of source introduction.
(5) Step of boron source introduction and deposition. Specifically, BCl₃ gas and oxygen (O₂) are introduced as per a certain ratio, a gas volume ratio of BCl₃ to O₂ is 1:1, and an introduction time is 20 min. In particular, a relatively low ratio may cause that BCl₃ cannot react with O₂ completely, resulting in excessive self-decomposition of BCl₃, and thus a large amount of elemental boron is deposited on the surface of silicon wafer to form a loss layer, and meanwhile, Cl₂ generated by the decomposition is very easy to corrode the surface of the silicon wafer. Whereas, a relatively high ratio may cause insufficient concentration of BCl₃, resulting in uneven distribution of gas sources in the quartz furnace tube, and thereby resulting in poor uniformity of whole tube.
(6) Step of heating-up. Specifically, after the boron source introduction and deposition is completed, the quartz furnace tube is evacuated again to remove BCl₃ and oxygen in the furnace tube until a target pressure of less than 100 mbar. After the evacuating is completed, heating-up is performed until a target temperature of 1000 °C.
(7) Step of propelling. Specifically, after reaching the target temperature of 1000 °C, going to the step of propelling. In the step of propelling, nitrogen (N₂) and oxygen (O₂) are alternately introduced for propelling, which includes: introducing 3000 sccm of nitrogen for 10 min, introducing 5000 sccm of oxygen for 25 min, introducing 3000 sccm of nitrogen for 10 min, and introducing 5000 sccm of oxygen for 25 min sequentially in that order.
(8) Step of cooling down and boat exiting. Specifically, cooling down to 800 °C and then the quartz boat is performed with an exiting operation to exit from the furnace tube, thereby completing the boron diffusion.

### Embodiment 2

A boron diffusion method suitable for HBC solar cells includes steps as follows.
(1) Step of boat entering. Specifically, silicon wafers after being texturing cleaned are placed into a horizontal insertion-type quartz boat, the silicon wafers are inserted into horizontal quartz grooves in a back-to-back manner, and then the quart boat is performed with an entering operation to enter a quartz furnace tube. When the quartz boat enters the quartz furnace tube, the quartz furnace tube has a temperature of 750°C, and simultaneously maintained with 2000 sccm of N₂ for continuous blowing.
(2) Step of heating-up. Specifically, the silicon wafers and the quartz boat after entering the quartz furnace tube are heated up with a heating rate of 10 °C/min until a target temperature of 800 °C, and the furnace tube is vacuumized through a vacuum pump while the heating-up. After the vacuumizing is completed, the vacuum pump is turned off and vacuum leak detection is performed as per a leak detection requirement of less than 5 mbar/min. After the leak detection is completed, the vacuum pump is turned on to adjust a pressure in the furnace tube until a target vacuum degree of 500 mbar.
(3) Step of pre-oxidation. Specifically, after reaching the target temperature and the target vacuum degree, 5000 sccm of oxygen is introduced for pre-oxidation for 20 min, and a thin silicon oxide layer is grown on a surface of the silicon wafer through the pre-oxidation. The thin silicon oxide layer serves as a barrier layer, which can prevent the surface of the silicon wafer from being damaged by chloride generated by decomposition of BCl₃ gas.
(4) After the pre-oxidation is completed, the furnace tube is evacuated to remove oxygen in the furnace tube, and a target pressure is less than 200 mbar, so as to prevent excessive oxygen from remaining in the furnace tube and thereby prevent excessive oxygen to consume a source of BCl₃ in a next step of source introduction.
(5) Step of boron source introduction and deposition. Specifically, BCl₃ gas and O₂ are introduced as per a certain ratio, a gas volume ratio of BCl₃ to O₂ is 1:3, and an introduction time is 10 min. In particular, a relatively low ratio may cause that BCl₃ cannot react with O₂ completely, resulting in excessive self-decomposition of BCl₃, and thus a large amount of elemental boron is deposited on the surface of silicon wafer to form a loss layer, and meanwhile, Cl₂ generated by the decomposition is very easy to corrode the surface of the silicon wafer. Whereas, a relatively high ratio may cause insufficient concentration of BCl₃, resulting in uneven distribution of gas sources in the quartz furnace tube, and thereby resulting in poor uniformity of whole tube.
(6) Step of heating-up. Specifically, after the boron source introduction and deposition is completed, the quartz furnace tube is evacuated again to remove BCl₃ and oxygen in the furnace tube until a target pressure of less than 100 mbar. After the evacuating is completed, heating-up is performed until a target temperature of 1000 °C.
(7) After reaching the target temperature of 1000 °C, going to a step of propelling. Specifically, in the propelling step, N₂ and O₂ are alternately introduced for propelling, which includes: introducing 4000 sccm of nitrogen for 10 min, introducing 6000 sccm of oxygen for 30 min, introducing 4000 sccm of nitrogen for 10 min, and introducing 6000 sccm of oxygen for 30 min sequentially in that order.

### Embodiment 3

A boron diffusion method suitable for HBC solar cells includes steps as follows.
(1) Step of boat entering. Specifically, silicon wafers after being texturing cleaned are placed into a horizontal insertion-type quartz boat, the silicon wafers are inserted into horizontal quartz grooves in a back-to-back manner, and then the quart boat is performed with an entering operation to enter a quartz furnace tube. When the quartz boat enters the quartz furnace tube, the quartz furnace tube has a temperature of 720°C, and simultaneously maintained with 2000 sccm of N₂ for continuous blowing.
(2) Step of heating-up and leak detection. Specifically, the silicon wafers and the quartz boat after entering the quartz furnace tube are heated up with a heating rate of 10 °C/min until a target temperature of 820 °C, and the furnace tube is vacuumized through a vacuum pump while the heating-up. After the vacuumizing is completed, the vacuum pump is turned off and vacuum leak detection is performed as per a leak detection requirement of less than 5 mbar/min. After the leak detection is completed, the vacuum pump is turned on to adjust a pressure in the furnace tube, and a target vacuum degree is 100 mbar.
(3) Step of pre-oxidation. Specifically, after reaching the target temperature and the target vacuum degree, 6000 sccm of oxygen is introduced for pre-oxidation for 10 min, and a thin silicon oxide layer is grown on a surface of the silicon wafer through the pre-oxidation. The thin silicon oxide layer serves as a barrier layer, which can prevent the surface of the silicon wafer from being damaged by chloride generated by decomposition of BCl₃ gas.
(4) After the pre-oxidation is completed, the furnace tube is evacuated to remove oxygen in the furnace tube, and a target pressure is less than 200 mbar, so as to prevent excessive oxygen from remaining in the furnace tube and thereby prevent excessive oxygen to consume a source of BCl₃ in a next step of source introduction.
(5) Step of boron source introduction and deposition. Specifically, BCl₃ gas and oxygen (O₂) are introduced as per a certain ratio, a gas volume ratio of BCl₃ to O₂ is 1:2, and an introduction time is 15 min. In particular, a relatively low ratio may cause that BCl₃ cannot react with O₂ completely, resulting in excessive self-decomposition of BCl₃, and thus a large amount of elemental boron is deposited on the surface of silicon wafer to form a loss layer, and meanwhile, Cl₂ generated by the decomposition is very easy to corrode the surface of the silicon wafer. Whereas, a relatively high ratio may cause insufficient concentration of BCl₃, resulting in uneven distribution of gas sources in the quartz furnace tube, and thereby resulting in poor uniformity of whole tube.
(6) Step of heating-up. Specifically, after the boron source introduction and deposition is completed, the quartz furnace tube is evacuated again to remove BCl₃ and oxygen in the furnace tube until a target pressure of less than 100 mbar. After the evacuating is completed, heating-up is performed until a target temperature of 1000 °C.
(7) Step of propelling. Specifically, after reaching the target temperature of 1000 °C, going to the step of propelling. In the step of propelling, N₂ and O₂ are alternately introduced for propelling, which includes: introducing 3000 sccm of nitrogen for 10 min, introducing 5000 sccm of oxygen for 30 min, introducing 3000 sccm of nitrogen for 10 min, and introducing 5000 sccm of oxygen for 30 min sequentially in that order.
(8) Step of cooling down and boat exiting. Specifically, cooling down to 800 °C and then the quartz boat is performed with an exiting operation to exit from the furnace tube, thereby completing the boron diffusion.

### Comparative example 1

In this comparative example, specific steps of boron diffusion are shown in TABLE 1 below.

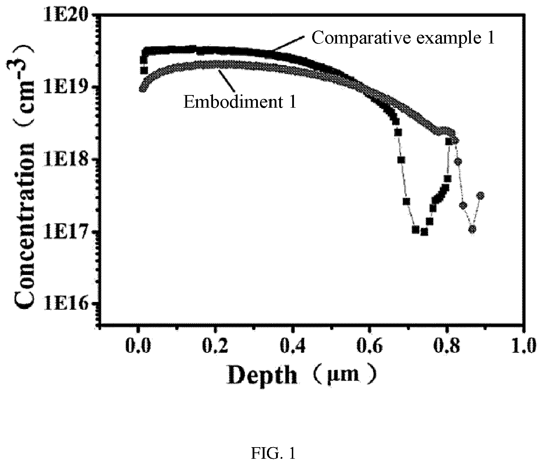

As seen from FIG. 1, the ECV results show that: the result obtained through the diffusion method according to the illustrated embodiment of the invention is that the junction depth is increased and the surface concentration is lower than that of the boron diffusion in the comparative example. A difference between latter parts of FIG. 1 of the two methods is mainly caused by different junction depths, and the surface concentration mainly depends on a concentration at the junction depth of 0-0.05 micrometers (µm).

**TABLE 1 Comparison of steps between the method of the comparative example 1 and the method according to the invention**

| Boron diffusion methods | |
|---|---|
| Method of the comparative example | Method according to the invention |
| Boat entering | Boat entering |
| Heating-up | Heating-up |
| Leak detection | Leak detection |
| Pre-oxidation | Pre-oxidation |
| 850 °C boron source introduction and deposition | 850 °C boron source introduction and deposition |
| Heating-up | Heating-up |
| 1000 °C oxygen propelling (40 min) | 1000 °C nitrogen propelling (10 min) |
| Cooling down | 1000 °C oxygen propelling (25 min) |
| Boat exiting | 1000 °C nitrogen propelling (10 min) |
| | 1000 °C oxygen propelling (25 min) |
| | Cooling down |
| | Boat exiting |

**TABLE 2**

| Comparison of doping concentrations and minority carrier lifetimes | | |
|---|---|---|
| Comparative items | Embodiment 1 | Comparative example 1 |
| doping concentration (cm⁻³) | 1.00E+ 19 | 2.00E+19 |
| minority carrier lifetime (µs) | 512 | 357 |
| Junction depth (µm) | 0.9 | 0.7 |

**TABLE 3 Diffusion sheet resistances corresponding to different regions of the furnace tube and uniformity of sheet resistance of intra-wafer**

| Regions | Comparative example 1 | | | Embodiment 1 | | |
|---|---|---|---|---|---|---|
| | furnace head | furnace middle | furnace tail | furnace head | furnace middle | furnace tail |
| Sheet resistances of 5 spots (Ω) | 109 | 118 | 108 | 111 | 110 | 110 |
| | 111 | 113 | 112 | 109 | 111 | 111 |
| | 106 | 118 | 115 | 111 | 111 | 111 |
| | 117 | 105 | 110 | 112 | 112 | 112 |
| | 106 | 116 | 118 | 111 | 111 | 111 |
| Averaging | 106 | 105 | 108 | 111 | 111 | 111 |
| Uniformity | 5.0% | 5.7% | 4.4% | 1.50% | 1.80 | 1.97% |

As seen from TABLE 2 and FIG. 1, the new boron diffusion method according to the illustrated embodiment of the invention can obtain a deeper PN junction and a lower surface doping concentration, the lower surface doping concentration can reduce a surface recombination rate of the solar cell and improve open-circuit voltage and current, and the deeper junction depth can enhance a field effect of a front surface of an N-type HBC solar cell and is beneficial to an improvement of fill factor (FF).

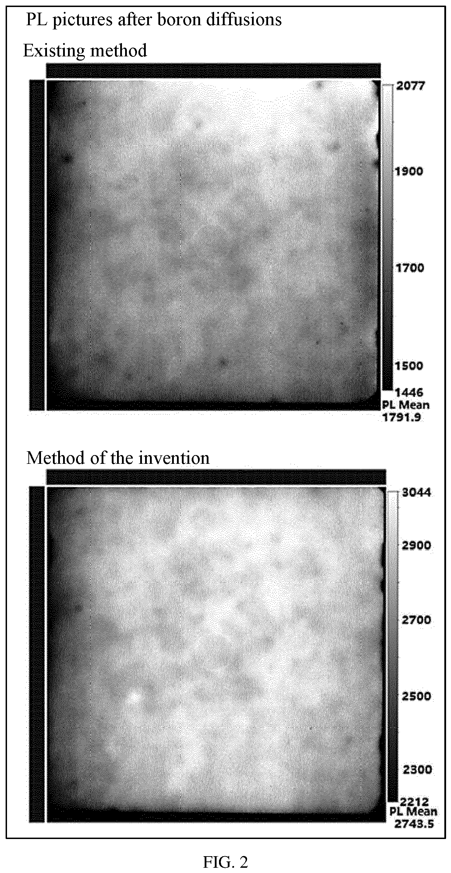

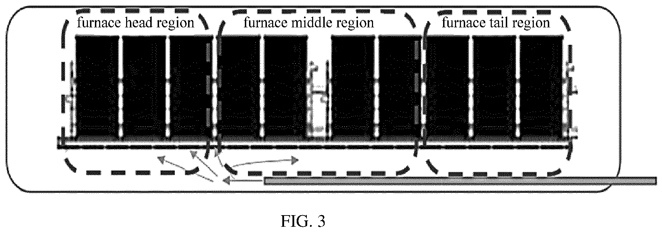

Before unloading of wafers (i.e., removing the silicon wafers from the quartz boat), the silicon wafers at different positions of the quartz boat are sampled and tested. Test positions are shown in FIG. 3, and test results are shown in TABLE 3. It can be seen from the data shown in TABLE 3 that: the method according to the illustrated embodiment of the invention has excellent intra-wafer and inter-wafer diffusion uniformity, which can further improve the consistency of PN junctions and facilitate lateral transport of carriers. FIG. 2 illustrates PL (photoluminescence) pictures of photovoltaic solar cells obtained after the boron diffusions using the method of the comparative example 1 and the method of the embodiment 1 of the invention, respectively. As seen from FIG. 2, the illustrated embodiment of the invention has better PL brightness and uniformity.

Apparently, the illustrated embodiments are merely some embodiments of the invention, and not all embodiments of the invention. Based on the illustrated embodiments of the invention, all other embodiments obtained by those of ordinary skill in the art without creative work should fall within the scope of protection of the invention.

## Claims

1. A boron diffusion method suitable for heterojunction back contact, HBC, solar cells, comprising:
step (1) of boating entering, comprising: placing silicon wafers in a boat and then performing an entering operation for the boat, wherein during performing the entering operation for the boat, a furnace tube has a temperature of 700-750 °C and simultaneously is maintained with 2000 standard cubic centimeter per minute, sccm, of nitrogen, N₂, for continuous blowing;
step (2) of heating-up and leak detection, comprising: heating-up after the boat enters the furnace tube until a target temperature of 800-850 °C, vacuumizing while the heating-up, turning off a vacuum pump and performing leak detection with a leak detection requirement of less than 5 mbar/min after completion of the vacuumizing; and after completion of the leak detection, turning on the vacuum pump to adjust a pressure in the furnace tube until a target vacuum degree of 100-500 mbar;
step (3) of pre-oxidation, comprising: after reaching the target temperature and the target vacuum degree, introducing 2000 sccm - 10000 sccm of oxygen, O₂, for pre-oxidation for 10-30 min;
step (4) of evacuating, comprising: after completion of the pre-oxidation, evacuating the furnace tube for an evacuation time of 3-10 min until a target pressure of less than 200 mbar;
step (5) of boron source introduction and deposition, comprising: introducing BCl₃ gas and oxygen for an introduction time of 5-20 min as per a gas volume ratio of the BCl₃ gas to the oxygen is 1:1 ~ 1:3;
step (6) of heating-up, comprising: after completion of boron source introduction and deposition, evacuating the furnace tube until a target pressure of less than 100 mbar and heating-up after completion of the evacuating until another target temperature of 1000 °C;
step (7) of propelling, comprising: after reaching the another target temperature, alternately introducing N₂ and O₂ for propelling according to a ratio of a N₂ propelling time to a O₂ propelling time being 1:2 ~ 1:3, a flow rate of the N₂ being 3 standard liter per minute, SLM, ~ 10 SLM and a flow rate of the O₂ being 5 SLM ~20 SLM in each time of propelling; and cyclically performing the propelling for 2-5 times; and
step (8) of cooling down and boat exiting, comprising: cooling down and then performing an exiting operation for the boat, thereby completing a diffusion process.

2. The boron diffusion method suitable for HBC solar cells according to claim 1, wherein in the step (2), a heating rate is 10 °C/min.

3. The boron diffusion method suitable for HBC solar cells according to claim 1, wherein in the step (7), after reaching the another target temperature, introducing 3000 sccm of the nitrogen for 10 min, introducing 5000 sccm of the oxygen for 25 min, introducing 3000 sccm of the nitrogen for 10 min, and introducing 5000 sccm of the oxygen for 25 min sequentially in that order.
